# EUROPÄISCHE PATENTANMELDUNG

(11) **EP 4 383 320 A1**
(43) Veröffentlichungstag der Anmeldung: **12.06.2024**
(21) Anmeldenummer: 22212592.4
(22) Anmeldetag: 09.12.2022
(51) Int. Cl.: H01L 21/67, H01L 21/677, H01L 21/683, H01L 21/68

(54) **VERFAHREN UND VORRICHTUNG ZUM SORTIEREN UND AUSRICHTEN VON HALBLEITERSCHEIBEN**

(71) Anmelder: Siltronic AG, 81677 München (DE)
(72) Erfinder: Moos, Patrick, 84568 Pleiskirchen (DE)
(74) Vertreter: Grundner, Sebastian

(57) **Zusammenfassung**

Verfahren zum Sortieren und Ausrichten von Halbleiterscheiben, umfassend die folgenden Schritte: Erkennung einer ersten Halterung für mehrere Halbleiterscheiben und deren Beladungszustand, Entnahme einer Halbleiterscheibe aus der ersten Halterung; Ausrichtung der Halbleiterscheibe gemäß einer vorgegebenen Orientierung; Erkennen und Auslesen einer Lasermarkierung auf der Halbleiterscheibe; Speicherung der in der Lasermarkierung enthaltenen Informationen in einer Datenbank oder einem Speichermedium; und Einsortieren der orientierten Halbleiterscheibe in eine zweite Halterung für mehrere Halbleiterscheiben; wobei diese Verfahrensschritte automatisiert durchgeführt werden. Vorrichtung zum Sortieren und Ausrichten von Halbleiterscheiben, mit einer Kammer und einer Steuerungseinheit (10), wobei die Kammer die folgenden Einheiten umfasst: eine erste Fixierung (8) für eine erste Halterung (9) für mehrere Halbleiterscheiben; eine zweite Fixierung (8) für eine zweite Halterung (9) für mehrere Halbleiterscheiben; einen Roboterarm (4) mit einem Endeffektor (6), der ein Auflageelement zur Aufnahme und zum Transport einer Halbleiterscheibe und einen optoelektronischen Sensor umfasst; eine Ablagestation (7) für eine Halbleiterscheibe, die so ausgestaltet ist, dass die Halbleiterscheibe mittels des Endeffektors (6) abgelegt und entnommen werden kann; eine Vorrichtung (11) zur Ausrichtung der Halbleiterscheibe mittels Drehung; und ein Lesegerät (12) zur Identifikation einer Lasermarkierung am Rand der Halbleiterscheibe; wobei die Steuerungseinheit (10) zur automatisierten Steuerung des Roboterarms ausgelegt ist, und der optoelektronische Sensor und das Lesegerät (12) mit einer Datenbank oder einem Speichermedium gekoppelt sind.

## Beschreibung

### Technisches Gebiet

Gegenstand der Erfindung ist ein Verfahren zum Sortieren und Ausrichten von Halbleiterscheiben und eine Vorrichtung zum Sortieren und Ausrichten von Halbleiterscheiben.

### Stand der Technik und technische Aufgabe

Anspruchsvolle Anwendungen auf dem Gebiet der Herstellung von Grundmaterial für die elektronische Industrie umfassen die Abscheidung einer Schicht aus Halbleitermaterial auf einer Substratscheibe, insbesondere die chemische Gasphasenabscheidung (Chemical Vapor Deposition, CVD) einer epitaktischen Schicht aus Halbleitermaterial auf einer Substratscheibe. Dabei wird ein Prozessgas, das reaktive gasförmige Vorläuferverbindungen (Precursor) enthält, über die Substratscheibe geleitet, wobei durch chemische Reaktion der gasförmigen Vorläuferverbindungen an der Oberfläche der Substratscheibe eine kristalline Materialschicht epitaktisch auf der Substratscheibe abgeschieden wird. Die Substratscheibe ist dabei bevorzugt eine Scheibe aus Halbleitermaterial, also eine Halbleiterscheibe.

Für die Abscheidung einer epitaktischen Schicht eines Halbleitermaterials auf einer Substratscheibe können Vorrichtungen, wie beispielsweise der in US 2009 314 205 A1 beschriebene Einzelscheiben-Reaktor verwendet werden. In modernen Planetenreaktoren, beispielsweise einem Reaktor des Typs AIX G5+ des Herstellers Aixtron, rotiert eine kreisscheibenförmige Suszeptorplatte, die mehrere als Satelliten bezeichnete Substrathalter trägt, um die eigene Achse. Ein solcher Planetenreaktor kann dementsprechend mehrere Substratscheiben mit Durchmessern von 80 bis 200 mm aufnehmen. So können beispielsweise 8 Substratscheiben mit einem Durchmesser von 150 mm oder 5 Substratscheiben mit einem Durchmesser von 200 mm gleichzeitig mittels chemischer Gasphasenabscheidung beschichtet werden.

Zur Handhabung der Halbleiterscheiben zwischen den verschiedenen Fertigungsschritten werden diese in Halterungen für mehrere Halbleiterscheiben zwischengelagert und in diesen Halterungen transportiert. Bei den auch als Horden oder Wafer-Carriern bezeichneten Halterungen handelt es sich üblicherweise um Kunststoffverpackungen. Die Temperaturbeständigkeit der Halterungen unterscheidet sich in Abhängigkeit des verwendeten Kunststoffmaterials stark. Das Material der Halterung und damit die Halterung insgesamt muss deshalb an die jeweilige Verwendung beziehungsweise den jeweiligen Fertigungsschritt angepasst werden. Wenn die Halbleiterscheiben nur bei Raumtemperatur gehandhabt werden, können günstigere, weniger temperaturbeständige Halterungen verwendet werden. Bei Bedarf kann dann eine Umsortierung in teurere Halterungen mit einer höheren Temperaturbeständigkeit und, optional, später wieder eine Umsortierung zurück in günstigere Halterungen erfolgen. Beispielsweise ist es für den Schritt der Abscheidung einer epitaktischen Schicht aus Halbleitermaterial auf einer Substratscheibe erforderlich, die Substratscheibe in eine temperaturbeständige Halterung umzusortieren.

Außerdem ist es vorteilhaft, die Halbleiterscheiben beim Umsortieren in eine andere Halterung gleich auszurichten. Die Ausrichtung erfolgt, indem der Notch oder der Flat der Halbleiterscheiben in einem vorgewählten Winkel in die Halterung einsortiert werden, so dass alle Halbleiterscheiben in der Halterung gleich ausgerichtet sind, wenn sie in axialer Blickrichtung betrachtet werden.

Bei dem oben beschriebenen Prozess der Umsortierung und Ausrichtung der Halbleiterscheiben muss zudem die Lasermarkierung am Scheibenrand identifiziert und notiert werden, um die Halbleiterscheiben identifizieren und ihre Prozessgeschichte dokumentieren zu können. Das Ablesen und Notieren der Lasermarkierungen durch eine Person ist ein fehleranfälliger Prozess. Deshalb erfolgt hier meist eine Kontrolle durch eine zweite Person. Der Schritt des Ablesens und Notieren der Lasermarkierungen ist somit zeit- und personalintensiv, und damit teuer und ineffizient.

Zudem kann zur Qualitätssicherung eine Begutachtung der Halbleiterscheiben erfolgen. Diese Begutachtung kann beispielsweise stichprobenartig oder auch an jeder Halbleiterscheibe vor, während oder nach der Umsortierung erfolgen.

Die oben genannten Schritte werden meist manuell mithilfe einer Vakuumpinzette unter Berührung der Scheibenvorderseite und der Scheibenrückseite durchgeführt. Gerade die manuelle Entnahme aus und die manuelle Rückgabe in die Halterung mittels der Vakuumpinzette ist vor allem bei sehr empfindlichen Galliumnitrid-beschichteten Halbleiterscheiben problematisch, bei denen eine solche Berührung von Vorder- und Rückseite der Scheiben zu erkennbaren Defekten, Kratzern, Rissen oder sogar zum Bruch führen kann. Gerade bei sehr riss- und bruchanfälligen Halbleiterscheiben mit einer Beschichtung aus Galliumnitrid können die mit dem Umsortieren, Ausrichten und Begutachten verbundenen Handhabungsschritte also zu Defekten auf der Oberfläche der Scheiben führen.

Die automatisierte Handhabung von Substratscheiben ist im Stand der Technik beschrieben. In der EP 1 701 378 B1 wird eine Substrattransfervorrichtung beschrieben, die darauf ausgerichtet ist, ein Substrat zu einer Substratverarbeitungsvorrichtung hin oder von ihr weg zu transferieren, um ein Substrat in einer vorbestimmten Atmosphäre zu verarbeiten. Die EP 3 341 831 A1 beschreibt eine Vorrichtung zur Verarbeitung eines Substrates, in welcher ein Roboterarm mit einem Endeffektor zum Transport des Substrates eingesetzt wird. Auch die US 2004/0253091 A1 beschreibt den Transport eines Substrats in eine Prozesskammer. Die US2020/0075380 A1 beschreibt eine Vorrichtung zur Ausrichtung von Substratscheiben.

Jedoch beschreibt keines dieser Dokumente ein automatisiertes Verfahren zum Sortieren von Halbleiterscheiben von einer ersten in eine zweite Halterung und zum Ausrichten von Halbleiterscheiben, wobei die Halterungen, deren Beladungszustand und die Markierungen auf den einzelnen Scheiben automatisch erkannt und gespeichert werden, so dass für keinen dieser Schritte eine manuelle Handhabung erforderlich ist.

Außerdem beschreibt keines dieser Dokumente eine Vorrichtung, die für ein solches Verfahren und für Halbleiterscheiben verschiedener Durchmesser geeignet ist. Gerade die Abscheidung einer Galliumnitrid-Schicht kann zu Spannungen in der Halbleiterscheibe führen. Deshalb kann eine Anpassung der Dicke der Substratscheibe erforderlich sein. Dementsprechend muss eine Vorrichtung zur Handhabung von Galliumnitrid-beschichteten Halbleiterscheiben auch für Scheiben unterschiedlicher Dicken geeignet sein.

Aufgabe der vorliegenden Erfindung ist es, ein effizientes und wirtschaftliches Verfahren bereitzustellen, das es ermöglicht, Halbleiterscheiben von einer Halterung in eine andere umzusortieren, die Halbleiterscheiben dabei zu identifizieren, auszurichten und gegebenenfalls die Halbleiterscheiben zu begutachten, ohne dass dabei Defekte auf der Vorder- und/oder Rückseite der Scheiben entstehen. Eine weitere Aufgabe der Erfindung ist die Bereitstellung einer Vorrichtung, die zur Durchführung eines solchen Verfahrens geeignet ist.

Gelöst wird die Aufgabe gemäß dem ersten Aspekt der vorliegenden Erfindung durch ein Verfahren zum Sortieren und Ausrichten von Halbleiterscheiben und gemäß dem zweiten Aspekt durch eine Vorrichtung zum Sortieren und Ausrichten von Halbleiterscheiben. Bevorzugte Ausführungsformen sind Gegenstand der abhängigen Ansprüche.

### Kurzbeschreibung der Figuren

**Figur 1** zeigt die erfindungsgemäße Vorrichtung von der Vorderseite aus betrachtet.
**Figur 2** zeigt die erfindungsgemäße Vorrichtung von der Rückseite aus betrachtet.

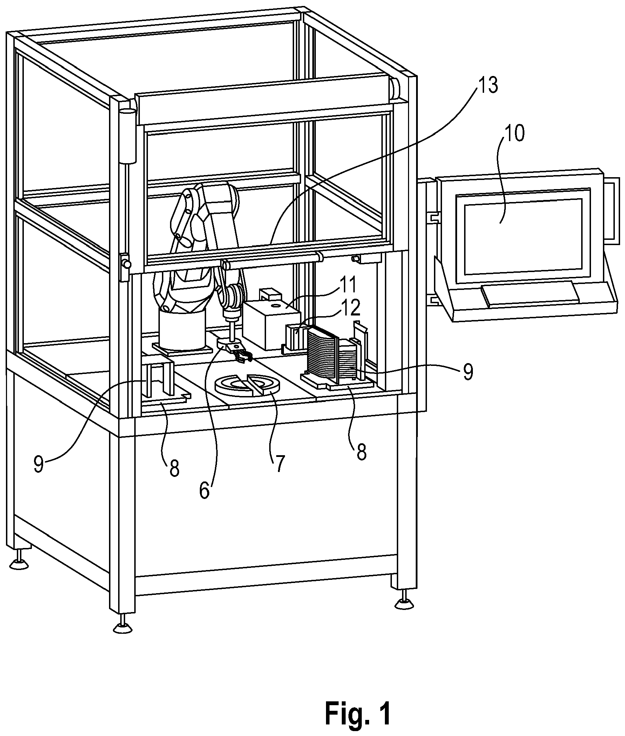

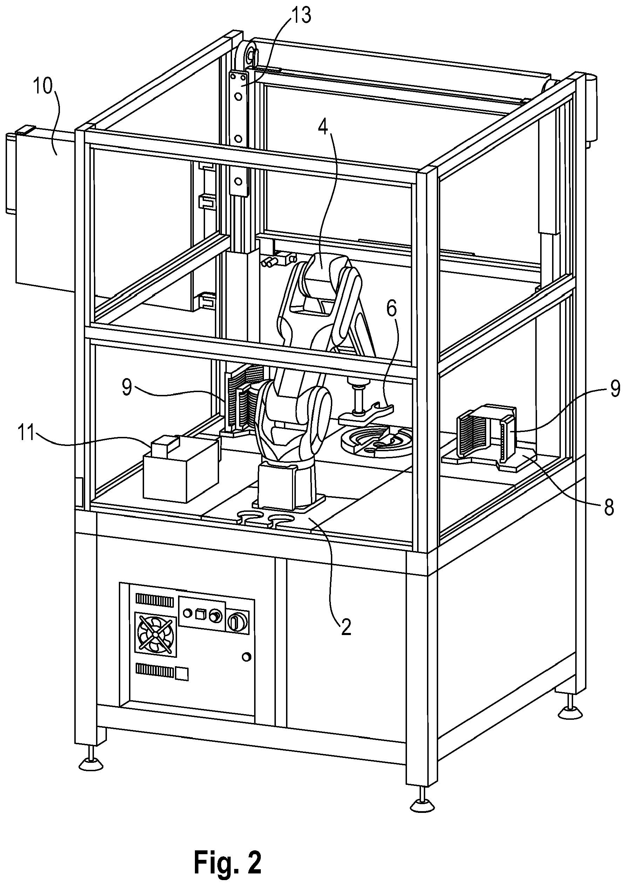

**Figur 1** und **2** zeigen
ein Umhausung mit Hubfenster (13),
eine erste und zweite Halterung (9),
Fixierungen für die erste und zweite Halterung (8),
einen Roboterarm (4) auf einer Grundplatte (2),
einen Endeffektor (6) mit einem Auflageelement für eine Halbleiterscheibe und einem optoelektronischen Sensor,
eine Ablagestation (7),
eine Vorrichtung zur Ausrichtung der Halbleiterscheibe mittels Drehung (11);
ein Lesegerät (12) zur Identifikation einer Lasermarkierung am Rand der Halbleiterscheibe, sowie
eine Steuerungseinheit (10) mit Monitor.

### Detaillierte Beschreibung der Erfindung

Das erfindungsgemäße Verfahren zum Sortieren und Ausrichten von Halbleiterscheiben gemäß dem ersten Aspekt umfasst die folgenden Schritte:
Erkennung einer ersten Halterung für mehrere Halbleiterscheiben und deren Beladungszustand;
Entnahme einer Halbleiterscheibe aus der ersten Halterung;
Ausrichtung der Halbleiterscheibe gemäß einer vorgegebenen Orientierung;
Erkennen und Auslesen einer Lasermarkierung auf der Halbleiterscheibe;
Speicherung der in der Lasermarkierung enthaltenen Informationen in einer Datenbank oder einem Speichermedium; und
Einsortieren der orientierten Halbleiterscheibe in eine zweite Halterung für mehrere Halbleiterscheiben;
wobei diese Verfahrensschritte automatisiert durchgeführt werden.

Vorzugsweise werden diese Schritte in der oben angegebenen Reihenfolge durchgeführt. Das Verfahren kann jedoch auch in einer anderen Reihenfolge durchgeführt werden, mit Ausnahme der ersten beiden Schritte, also der Erkennung einer ersten Halterung und der Entnahme einer Halbleiterscheibe, und dem letzten Schritt, also dem Einsortieren der orientierten Halbleiterscheibe.

Eine Halbleiterscheibe im Sinne der vorliegenden Erfindung ist eine Scheibe aus Halbleitermaterial. Die Halbleiterscheibe kann dabei eine beschichtete oder unbeschichtete Scheibe aus Halbleitermaterial sein. Eine unbeschichtete Scheibe aus Halbleitermaterial ist vorzugsweise eine Scheibe aus einkristallinem Silizium, Germanium, Siliziumcarbid oder Galliumnitrid. Die Halbleiterscheibe hat vorzugsweise einen Durchmesser von 150 bis 300 mm, besonders bevorzugt von 150 bis 200 mm, am meisten bevorzugt 200 mm. Die Vorderseite der Halbleiterscheibe ist vorzugsweise <100>-orientiert oder <110>-orientiert. Eine unbeschichtete Scheibe aus Halbleitermaterial kann dabei als Substratscheibe für die chemische Gasphasenabscheidung einer epitaktischen Schicht aus Halbleitermaterial dienen. Eine beschichtete Scheibe aus Halbleitermaterial besteht vorzugsweise aus einer unbeschichteten Scheibe aus Halbleitermaterial, auf der mittels chemischer Gasphasenabscheidung einer epitaktischen Schicht aus Halbleitermaterial abgeschieden wurde, beispielsweise eine epitaktische Schicht aus Silizium oder Galliumnitrid. Eine Halbleiterscheibe im Sinne der vorliegenden Erfindung kann also sowohl eine Substratscheibe als auch eine Halbleiterscheibe mit einer epitaktischen Schicht aus Halbleitermaterial sein.

Das Verfahren kann sowohl automatisiert entsprechend eines vorher festgelegten Programmes oder über eine Steuerungseinheit an einer geeigneten Vorrichtung, wie beispielsweise der Vorrichtung gemäß dem zweiten Aspekt der vorliegenden Erfindung, durchgeführt werden. Unter Automatisierung versteht man nach DIN V 19233 das Ausrüsten einer Vorrichtung, so dass sie ganz oder teilweise ohne Mitwirkung des Menschen bestimmungsgemäß arbeitet. Dementsprechend ist ein automatisiertes Verfahren im Sinne der vorliegenden Erfindung ein Verfahren, das ganz oder teilweise ohne Mitwirkung eines Menschen bestimmungsgemäß abläuft. Ein vollautomatisiertes Verfahren im Sinne der vorliegenden Erfindung ist ein Verfahren, das ganz ohne Mitwirkung eines Menschen, abgesehen von der vorherigen Planung und Programmierung durch einen Menschen, bestimmungsgemäß abläuft. Ein vollautomatisierter Verfahrensschritt läuft dementsprechend nach Abschluss der Planung und Programmierung ohne Mitwirkung eines Menschen ab.

Durch die automatisierten, bevorzugt vollautomatisierten, Verfahrensschritte ist eine gleichzeitig zuverlässige, effiziente, wirtschaftliche und schonenden Behandlung der Halbleiterscheiben gewährleistet. Zudem können durch die automatische Erkennung und Speicherung der Lasermarkierungen der Halbleiterscheiben Ablese- und Eingabefehler verhindert werden. Vorzugsweise werden die oben genannten Verfahrensschritte des erfindungsgemäßen Verfahrens vollautomatisch durchgeführt.

Vorzugsweise wird das Verfahren durch eine programmierbare Steuereinheit gesteuert. Dies ermöglicht es, dass alle Verfahrensschritte automatisiert durchgeführt und durch einfache Programmbefehle einfach ausgewählt und geändert werden können. Somit ist eine einfache und unkomplizierte Modifikation der Verfahrensschritte und des Verfahrens insgesamt möglich, so dass das erfindungsgemäße Verfahren einfach programmierbar ist.

Die erste Halterung ist vorzugsweise eine Halterung zur Aufnahme von 25 Halbleiterscheiben mit einem Durchmesser von 100 bis 300 mm, besonders bevorzugt 150 bis 200 mm. Beispielsweise kann die Halterung für Scheiben mit einem Durchmesser von 150 mm oder 200 mm geeignet sein.

Das Aufsetzen der ersten und zweiten Halterung erfolgt manuell. Danach erfolgt der Start des erfindungsgemäßen Verfahrens, vorzugsweise mittels eines Programmes, das über eine Steuerungseinheit konfiguriert, ausgewählt und gestartet werden kann. Wird das erfindungsgemäße Verfahren innerhalb einer geschlossenen Kammer einer dafür vorgesehenen Vorrichtung durchgeführt, wird vorzugsweise vor dem Start des Verfahrens die Kammer geschlossen, beispielsweise durch das Schließen einer Sicherheitstür.

Die Erkennung der ersten Halterung für mehrere Halbleiterscheiben und deren Beladungszustand erfolgt vorzugsweis mit Hilfe eines Sensors. Vorzugsweise ist der Sensor am Ende des Roboterarms, also am Endeffektor, angebracht. Der Sensor ist vorzugsweise ein optoelektronischer Sensor, der eine Lichtquelle umfasst, beispielsweise ein Wafer Mapping Sensor.

Durch die Erkennung der ersten Halterung und deren Beladungszustand wird die Anzahl und Position sämtlicher Scheiben in der Halterung bestimmt, so dass vermieden werden kann, dass bei der Entnahme einer bestimmten Halbleiterscheibe aus der Halterung diese oder eine andere in der Halterung befindliche Scheibe durch den Roboterarm, insbesondere durch den Endeffektor, beschädigt wird. Die Erkennung der ersten Halterung und deren Beladungszustand erfolgt mithilfe eines optoelektronischen Sensors und einer Lichtquelle. Dabei emittiert die Lichtquelle vorzugsweise rotes Licht, insbesondere Licht mit einer Wellenlänge von 600 bis 750 nm, besonders bevorzugt 650 bis 750 nm. Aufgrund der starken Reflektion des von der Lichtquelle emittierten Lichtes an den Kanten der Halbleiterscheiben können die besetzten Positionen in der Halterung, eventuelle Doppelbeladungen bestimmter Positionen und Schieflagen von Halbleiterscheiben in bestimmten Positionen mit Hilfe des optoelektronischen Sensors identifiziert werden.

Die Entnahme einer Halbleiterscheibe aus der ersten Halterung erfolgt vorzugsweise mittels eines Endeffektors. Ein Endeffektor ist das letzte Element einer kinematischen Kette, beispielsweise der Greifer oder ein Auflageelement eines Roboterarms. In einer bevorzugten Ausführungsform handelt es sich bei dem Endeffektor um ein Auflageelement, das an das Ende eines Roboterarms angebracht ist. Das Auflageelement ist beispielsweise ein hufeisenförmiges Bauteil, vorzugsweise ein dünnes, hufeisenförmiges Blech.

Nach der Entnahme wird die Halbleiterscheibe zu einer Vorrichtung transportiert, an der die Halbleiterscheibe ausgerichtet werden kann.

Nach der Ablage auf der Vorrichtung erfolgt die Ausrichtung der Halbleiterscheibe gemäß einer vorgegebenen Orientierung, das Erkennen und Auslesen einer Lasermarkierung auf der Halbleiterscheibe und die Speicherung der in der Lasermarkierung enthaltenen Informationen in einer Datenbank oder einem Speichermedium.

Dabei kann entweder zuerst die Ausrichtung der Scheibe und darauffolgend das Erkennen und Auslesen der Lasermarkierung erfolgen, oder alternativ, zuerst die Erkennung und das Auslesen einer Lasermarkierung und darauffolgend die Ausrichtung der Halbleiterscheibe erfolgen.

Die Ausrichtung erfolgt vorzugsweise, indem der Notch oder der Flat der Halbleiterscheiben in einem vorgewählten Winkel auf einer dafür vorgesehenen Vorrichtung ausgerichtet werden, so dass alle Halbleiterscheiben nach dem Einsortieren in die zweiten Halterung gleich ausgerichtet sind, wenn sie in axialer Richtung betrachtet werden. Ein Notch ist eine kleine Einkerbung am Rand einer Halbleiterscheibe, die dazu dient, die Scheibe in der Fertigung exakt ausrichten zu können. Ein Flat ist eine seitliche Abflachung einer Halbleiterscheibe und dient ebenfalls dazu, die Scheibe in der Fertigung exakt ausrichten zu können. Weil die Einkerbung weniger Fläche als die seitliche Abflachung beansprucht, ist der Notch gegenüber dem Flat bevorzugt. Vorzugsweise werden die Halbleiterscheiben bei der Ausrichtung auch zentriert.

Die Vorrichtung zur Ausrichtung der Halbleiterscheibe umfasst vorzugsweise eine drehbar gelagerte Ablagefläche. Die Ablagefläche ist vorzugsweise kreisscheibenförmig. Durch Drehung der Ablagefläche mittels eines Motors oder Servos kann die Halbleiterscheibe in die gewünschte Ausrichtung überführt werden. Eine solche Vorrichtung wird auch als Prealigner bezeichnet. Die Vorrichtung ist vorzugsweise einen dreiachsigen Prealigner der Serie LPA des Herstellers Logosol Inc. USA.

Das Erkennen und Auslesen der Lasermarkierung auf der Halbleiterscheibe erfolgt vorzugsweise mittels eines Lesegerätes, das die Identifikation-Kennung am Scheibenrand identifiziert und in eine Datenbank oder ein Speichermedium einliest. Das Erkennen und Auslesen der Lasermarkierung erfolgt vorzugweise gemäß einem der Industriestandards SEMI M12, SEMI M13, SEMI M1.15 oder SEMI T1.95. Die Lasermarkierung ist beispielsweise ein 2D Code, ein Barcode oder ein Schriftzug, besonders bevorzugt ein der Texterkennung zugänglicher Schriftzug.

Anschließend erfolgt der Schritt des Einsortierens der ausgerichteten Halbleiterscheibe in eine zweite Halterung für mehrere Halbleiterscheiben. Dabei wir die Halbleiterscheibe zunächst mittels eines Endeffektors von der Vorrichtung zur Ausrichtung der Halbleiterscheibe entnommen, zur zweiten Halterung transportiert und in diese Einsortiert. Optional kann dabei der Beladungszustand der zweiten Halterung vor diesem Schritt mittels des optoelektronischen Sensors bestimmt werden. Dieser Schritt kann während des Transports und vor dem Einsortieren in die zweite Halterung, vor der Entnahme der Halbleiterscheibe aus der ersten Halterung oder auch vor der Entnahme von der Vorrichtung zur Ausrichtung der Halbleiterscheibe erfolgen. Optional kann das erfindungsgemäße Verfahren also auch einen zusätzlichen Schritt zur Erkennung der zweiten Halterung für mehrere Halbleiterscheiben und deren Beladungszustand umfassen. Vorzugsweise wird dieser Schritt automatisiert, besonders bevorzugt vollautomatisiert, durchgeführt. Besonders bevorzugt erfolgt der Schritt zur Erkennung der zweiten Halterung analog dem Schritt zur Erkennung der ersten Halterung.

Die zweite Halterung hat vorzugsweise eine höhere Temperaturbeständigkeit als die erste Halterung. Die zweite Halterung ist vorzugsweise eine Halterung zur Aufnahme von 25 Halbleiterscheiben mit einem Durchmesser von 100 bis 300 mm, mehr bevorzugt 150 bis 200 mm. Dabei können die Halbleiterscheiben entweder in der gleichen oder in einer anderen Reihenfolge als in der ersten Halterung einsortiert werden. Vorzugsweise werden die Halbleiterscheiben in gleicher oder in umgekehrter Reihenfolge im Vergleich zur ersten Halterung einsortiert.

Vorzugsweise wird das erfindungsgemäße Verfahren für alle Halbleiterscheiben der ersten Halterung nacheinander durchgeführt, so dass alle Halbleiterscheiben von der ersten in die zweite Halterung für Halbleiterscheiben überführt werden. Vorzugsweise werden so 1 bis 25 Halbleiterscheiben, am meisten bevorzugt 25 Halbleiterscheiben, von der ersten in die zweite Halterung für Halbleiterscheiben überführt. Dabei können beim Umsortieren auch Fertigungslose für die Abscheidung einer epitaktischen Schicht eines Halbleitermaterials in einem Planetenreaktor gegründet werden. Beispielsweise können Fertigungslose von 5 Substratscheiben mit einem Durchmesser von 200 mm oder Fertigungslose von 8 Substratscheiben mit einem Durchmesser von 150 mm gebildet werden.

Optional umfasst das Verfahren einen Schritt zur Begutachtung einer oder mehrerer Halbleiterscheiben aus der ersten Halterung, wobei die Begutachtung vor, während oder nach dem Schritt des Umsortierens von der ersten in die zweite Halterung stattfindet, besonders bevorzugt während des Umsortierens. Für die Begutachtung kann die Halbleiterscheibe auf einer dafür vorgesehenen Ablagefläche abgelegt werden und dort beispielsweise mittels einer Rückenseitenpinzette entnommen und anschließend untersucht werden. Nach Beendigung der Begutachtung kann die Halbleiterscheibe wieder auf der Ablagefläche abgelegt und anschließend, bevorzugt von dem Roboterarm, von der Ablagefläche in die erste oder zweite Halterung einsortiert werden. Dieser Schritt kann manuell, automatisch oder vollautomatisch erfolgen. Optional kann eine aus der ersten Halterung entnommene Halbleiterscheibe auf der Ablagefläche zwischengelagert werden.

Vorzugsweise erfolgen alle Schritte des erfindungsgemäßen Verfahrens automatisiert oder vollautomatisiert, mit Ausnahme des optionalen Schrittes der Begutachtung einer Halbleiterscheibe. Dieser Schritt wird vorzugsweise manuell von einem Menschen durchgeführt. In einer besonders bevorzugten Ausführungsform ist das erfindungsgemäße Verfahren vollautomatisiert, wobei die Beladung der Vorrichtung mit der ersten und zweiten Halterung vor dem Beginn des Verfahrens und die Entnahme der ersten und zweiten Halterung nach dem Abschluss des Verfahrens manuell erfolgt. Der optionale Schritt der Begutachtung wird vorzugsweise ebenfalls manuell durchgeführt. Nach der Begutachtung kann die Halbleiterscheibe wieder auf der Ablagefläche abgelegt, automatisch in die erste oder zweite Halterung einsortiert und gegebenenfalls automatisch ausgerichtet werden. Durch die Automatisierung ist eine hohe Verfahrensgeschwindigkeit erreichbar. So können mit dem erfindungsgemäßen Verfahren bis zu 160 Halbleiterscheiben in 8 Stunden (20 Halbleiterschieben pro Stunde) umsortiert und ausgerichtet werden. Beispielsweise können mit dem erfindungsgemäßen Verfahren 100 bis 160, vorzugsweise 100 bis 120, besonders bevorzugt 100, Halbleiterscheiben in 8 Stunden umsortiert und ausgerichtet werden.

Vorzugsweise finden alle Schritte des erfindungsgemäßen Verfahrens in einem Reinraum der Klasse 4 oder niedriger, vorzugsweise der Klassen 1 bis 3, statt. Die Klassifizierung des Reinraumes erfolgt dabei nach ISO EN 14644-1.

In einer bevorzugten Ausführungsform wir das erfindungsgemäße Verfahren mittels der im folgenden beschriebenen Vorrichtung durchgeführt.

Gemäß dem zweiten Aspekt ist die vorliegende Erfindung auf eine Vorrichtung zum Sortieren und Ausrichten von Halbleiterscheiben gerichtet. Die erfindungsgemäße Vorrichtung umfasst eine Kammer und eine Steuerungseinheit (10), wobei die Kammer die folgenden Einheiten umfasst.
eine erste Fixierung (8) für eine erste Halterung (9) für mehrere Halbleiterscheiben;
eine zweite Fixierung (8) für eine zweite Halterung (9) für mehrere Halbleiterscheiben;
einen Roboterarm (4) mit einem Endeffektor (6), der ein Auflageelement zur Aufnahme und zum Transport einer Halbleiterscheibe und einen optoelektronischen Sensor umfasst;
eine Ablagestation (7) für eine Halbleiterscheibe, die so ausgestaltet ist, dass die Halbleiterscheibe mittels des Endeffektors (6) abgelegt und entnommen werden kann;
eine Vorrichtung (11) zur Ausrichtung der Halbleiterscheibe mittels Drehung; und
ein Lesegerät (12) zur Identifikation einer Lasermarkierung am Rand der Halbleiterscheibe;
wobei die Steuerungseinheit (10) zur automatisierten Steuerung des Roboterarms ausgelegt ist, und
der optoelektronische Sensor und das Lesegerät (12) mit einer Datenbank oder einem Speichermedium gekoppelt sind.

Die erste Fixierung für eine erste Halterung für mehrere Halbleiterscheiben und die zweite Fixierung für eine zweite Halterung für mehrere Halbleiterscheiben sind vorzugsweise am Boden der Kammer befestigt. Dabei sind die Fixierungen so ausgestaltet, dass die Halterungen reversibel befestigt werden können. Die erste und die zweite Halterung können dabei aus Kunststoff oder aus Quarzglas bestehen. Die erste Halterung ist vorzugsweise eine Transportbox aus Kunststoff für 25 Halbleiterscheiben, besonders bevorzugt eine FOSB-Kassette, die auch als Front Opening Shipping Box bezeichnet wird. Die zweite Halterung kann ebenfalls eine Transportbox aus Kunststoff für 25 Halbleiterscheiben sein, besonders bevorzugt eine FOSB-Kassette. In einer bevorzugten Ausführungsform ist die zweite Halterung aus einem temperaturbeständigen Kunststoff und ist für die Aufnahme von 1 bis 25, vorzugsweise 5 bis 10, Halbleiterscheiben ausgelegt.

Der Roboterarm besteht vorzugsweise aus einer Basis, einer Achse mit Antriebseinheiten auf der Basis, und mehreren Verbindungselemente für den strukturellen Aufbau und die mechanische Kopplung der Achsen. Die Basis ist vorzugsweise eine Grundplatte, auf der ein Gehäuse, dass die Antriebseinheit umfasst, aufgesetzt ist. Die Antriebseinheit umfasst vorzugsweise einen Motor, ein Getriebe und einen Winkelgeber. Auf das Gehäuse können die Verbindungselemente für den strukturellen Aufbau und die mechanische Kopplung der Achsen aufgebracht werden, also beispielsweise die über Gelenke miteinander verbundenen Glieder des Roboterarms. Der Roboterarms umfasst Leitungen und Kabel zur Energieversorgung, Ansteuerung und Signalübertragung.

Der Roboterarm ist mit einem Endeffektor zur Aufnahme, zum Transport und zur Ablage einer Halbleiterscheibe und mit einem optoelektronischen Sensor ausgestattet. In einer bevorzugten Ausführungsform handelt es sich bei dem Endeffektor um ein Auflageelement, das an das Ende eines Roboterarms, also an dessen Endglied, angebracht ist. Das Auflageelement ist beispielsweise ein hufeisenförmiges Bauteil, vorzugsweise ein dünnes, hufeisenförmiges Blech. Vorzugsweise ist der Endeffektor mit einer Unterdruckversorgung ausgestattet, so dass eine Halbleiterscheibe auf die Auflagefläche aufgelegt und durch Unterdruck an diese fixiert werden kann.

Vorzugsweise ist auch der optoelektronische Sensor am Ende des Roboterarms angebracht. Beispielsweise sind das Auflageelement und der optoelektronische Sensor an gegenüberliegenden Enden des Endeffektor angebracht. Der optoelektronische Sensor umfasst vorzugsweise eine Lichtquelle und ist besonders bevorzugt ein Wafer Mapping Sensor. Dabei emittiert die Lichtquelle des Wafer Mapping Sensors einen Lichtstrahl, beispielsweise einen roten Lichtstrahl, der von der Halbleiterscheibe reflektiert wird. Die Lichtquelle ist vorzugsweise eine LED, die rotes Licht, vorzugsweise Licht mit einer Wellenlänge von 600 bis 750 nm, besonders bevorzugt 650 bis 750 nm, emittiert. Durch die Detektion des von den Halbleiterscheiben reflektierten Lichtes durch den optoelektronischen Sensor kann mittels eines Computerprogrammes die Position der Halbleiterscheiben ermittelt werden. Der optoelektronische Sensor ist beispielsweise eine Wafer Mapping Sensor des Typs M-DW1 des Herstellers Panasonic.

Die erfindungsgemäße Vorrichtung umfasst eine Ablagestation für eine Halbleiterscheibe, die so ausgestaltet ist, dass die Halbleiterscheibe mittels des Endeffektors abgelegt und entnommen werden kann. Für die Begutachtung kann die Halbleiterscheibe auf die Ablagefläche der Ablagestation abgelegt werden und dort beispielsweise mittels einer Rückenseitenpinzette entnommen und anschließend untersucht werden. Die Ablagestation umfasst vorzugsweise mehrere konzentrisch angeordnete Stufen, die zum Kreismittelpunkt hin absteigen. Der ringförmige Umlauf der Stufen wird vorzugsweise durch einen Spalt über den gesamten Durchmesser in radialer Richtung durchbrochen. Der Spalt ist bevorzugt quaderförmig. Durch den Spalt werden die Stufen der Ablagestation in zwei gleichgroße Kreissegmente unterteilt. Vorzugsweise sind die Stufen mit Einstecköffnungen für Auflageelemente, wie beispielsweise Pins, ausgestaltet. Dabei sind die Einstecköffnungen vorzugsweise konzentrisch so auf den Stufen angeordnet, dass die Auflageelemente so in die Einstecköffnungen gesteckt werden können, dass eine konzentrische Auflagefläche, vorzugsweise zur Randauflage der Scheibe, gebildet wird. Aufgrund der unterschiedlichen Radien der verschiedenen Stufen ist die Ablagestation für die Auflage von Halbleiterscheiben unterschiedlicher Durchmesser geeignet, vorzugsweise für Halbleiterscheiben mit einem Durchmesser von 100 bis 300 mm, mehr bevorzugt 150 bis 200 mm. Der Spalt ist dabei so breit, dass der Endeffektor in den Spalt eingeführt und so die Halbleiterscheibe auf der von den Auflageelementen gebildeten Ablagefläche abgelegt oder von der Ablagefläche aufgenommen werden kann.

Die erfindungsgemäße Vorrichtung umfasst eine Vorrichtung zur Ausrichtung der Halbleiterscheibe mittels Drehung. Die Vorrichtung zur Ausrichtung der Halbleiterscheibe umfasst vorzugsweise eine drehbar gelagerte Ablagefläche. Die Ablagefläche ist vorzugsweise kreisscheibenförmig. Durch Drehung der Ablagefläche mittels eines Motors oder Servos, der in der Basis unterhalb der Ablagefläche enthalten ist, kann die Halbleiterscheibe in die gewünschte Ausrichtung überführt werden. Die Ausrichtung erfolgt dabei durch eine entsprechende Ausrichtung des Notch oder des Flats der Halbleiterscheibe. Außerdem ist die Vorrichtung zur Ausrichtung der Halbleiterscheibe mittels Drehung so ausgestaltet, dass die Halbleiterscheibe auf ihr zentriert werden kann. Eine solche Vorrichtung wird auch als Prealigner bezeichnet. Die Vorrichtung ist vorzugsweise ein dreiachsiger Prealigner. Die erfindungsgemäße Vorrichtung umfasst vorzugsweise einen dreiachsigen Prealigner der Serie LPA des Herstellers Logosol Inc. USA.

Außerdem umfasst die erfindungsgemäße Vorrichtung ein Lesegerät. Das Lesegerät ist so ausgestaltet, dass es zum Erkennen und Auslesen der Lasermarkierung am Rand der Halbleiterscheibe, insbesondere der Identifikation-Kennung am Scheibenrand, geeignet ist. Das Lesegerät identifiziert die Markierung und liest die in der Markierung enthaltenen Information in eine Datenbank oder ein Speichermedium ein. Das Erkennen und Auslesen der Lasermarkierung erfolgt vorzugweise gemäß einem der Industriestandards SEMI M12, SEMI M13, SEMI M1.15 oder SEMI T1.95. Die Lasermarkierung ist beispielsweise ein 2D Code, ein Barcode oder ein Schriftzug, besonders bevorzugt ein der Texterkennung zugänglicher Schriftzug. Vorzugsweise ist das Lesegerät an der Vorrichtung zur Ausrichtung der Halbleiterscheibe mittels Drehung angebracht, besonders bevorzugt seitlich an der Basis der Vorrichtung unterhalb der drehbar gelagerte Ablagefläche, wobei das Lesegerät nach oben ausgerichtet ist.

Die Steuerungseinheit der erfindungsgemäßen Vorrichtung ist zur automatisierten Steuerung und Programmierung der Vorrichtung, insbesondere des Roboterarms, des optoelektronischen Sensors, des Lesegerätes und der Vorrichtung zur Ausrichtung der Halbleiterscheibe, ausgelegt. Die Steuerungseinheit ist vorzugsweise ein Programmiergerät des Typs iPendant des Herstellers FANUC.

Vorzugsweise sind alle Elemente der erfindungsgemäßen Vorrichtung so ausgestaltet, dass mit der Vorrichtung Halbleiterscheiben unterschiedlicher Dicke und mit unterschiedlichem Durchmesser ausgerichtet, sortiert und begutachtet werden können. Die Vorrichtung ist vorzugsweise für Halbleiterscheiben mit einem Durchmesser von 100 bis 300 mm, besonders bevorzugt 150 bis 200 mm, geeignet. Insbesondere das Auflageelement zur Aufnahme und zum Transport einer Halbleiterscheibe, die Vorrichtung zur Ausrichtung der Halbleiterscheibe mittels Drehung und die Ablagestation sind vorzugsweise für Halbleiterscheiben mit einem Durchmesser von 100 bis 300 mm, besonders bevorzugt 150 bis 200 mm ausgelegt. Die Vorrichtung ist vorzugsweise für Halbleiterscheiben mit Dicken von 500 bis 1500 µm, vorzugsweise 650 bis 950 µm, geeignet. Somit können unterschiedliche Halbleiterscheiben mit der Vorrichtung sortiert, ausgerichtet und begutachtet werden. Damit ist die erfindungsgemäße Vorrichtung flexibel und kosteneffizient für verschiedene Produkte einsetzbar.

Die Kammer wird vorzugsweise von einer Umhausung aus einem Metallrahmen mit transparenten Flächenelementen gebildet. Die Umhausung ist vorzugsweise quaderförmig. Besonders bevorzugt besteht die Kammer aus einer vierseitigen Umhausung aus einem Aluminiumrahmen und transparenten Flächenelementen aus Kunststoff, vorzugsweise aus PET. Die Umhausung ist vorzugsweise mit einem Hubfenster ausgestattet. Über das Hubfenster hat eine Person Zugriff auf die Vorrichtung im Inneren der Kammer, insbesondere auf eine auf der Ablagestation abgelegte Halbleiterscheibe, so dass eine persönliche Begutachtung oder Entnahme der Halbleiterscheiben oder Wartungsarbeiten möglich sind.

Der optoelektronische Sensor und das Lesegerät sind mit einer Datenbank oder einem Speichermedium verbunden, so dass die von dem optoelektronischen Sensor und dem Lesegerät ermittelten Informationen gespeichert werden können. So kann beispielsweise die Position einer Halbleiterscheibe in der ersten und/oder zweiten Halterung, die in der Lasermarkierung enthaltene Information zu dieser Halbleiterscheibe, und die Ausrichtung der Halbleiterscheibe in der ersten und/oder zweiten Halterung gespeichert werden. Die Steuerungseinheit und die Energieversorgung sind vorzugsweise unterhalb der Kammer angeordnet. Vorzugsweise ist die erfindungsgemäße Vorrichtung für einen Reinraum der Klasse 4 oder niedriger, vorzugsweise der Klassen 1 bis 3, geeignet. Die Klassifizierung des Reinraumes erfolgt dabei nach ISO EN 14644-1. Außerdem ist die erfindungsgemäße Vorrichtung dafür geeignet, bis zu 160 Halbleiterscheiben, vorzugsweise 100 bis 120 Halbleiterscheiben, in 8 Stunden umzusortieren und auszurichten.

Das Speichermedium ist beispielsweise der Datenspeicher eines Rechners oder eine externe Datenverarbeitungseinheit.

### Detaillierte Beschreibung erfindungsgemäßer Ausführungsbeispiele

Die Figuren 1 und 2 zeigen die Merkmale einer zur Durchführung des erfindungsgemäßen Verfahrens geeigneten Vorrichtung aus verschiedenen Perspektiven. Diese umfasst eine Kammer mit einem Hubfenster (13) und eine Steuerungseinheit (10), wobei die Kammer die folgenden Einheiten umfasst:
eine erste Fixierung (8) für eine erste Halterung (9) für mehrere Halbleiterscheiben;
eine zweite Fixierung (8) für eine zweite Halterung (9) für mehrere Halbleiterscheiben;
einen Roboterarm (4) mit einem Endeffektor (6), der ein Auflageelement zur Aufnahme und zum Transport einer Halbleiterscheibe und einen optoelektronischen Sensor umfasst;
eine Ablagestation (7) für eine Halbleiterscheibe; die so ausgestaltet ist, dass die Halbleiterscheibe mittels des Endeffektors (6) abgelegt und entnommen werden kann;
eine Vorrichtung (11) zur Ausrichtung der Halbleiterscheibe mittels Drehung; und
ein Lesegerät (12) zur Identifikation einer Lasermarkierung am Rand der Halbleiterscheibe;
wobei die Steuerungseinheit (10) zur automatisierten Steuerung des Roboterarms (4) ausgelegt ist, und der optoelektronische Sensor und das Lesegerät (12) mit einer Datenbank oder einem Speichermedium gekoppelt sind.

Die Kammer ist eine vierseitige, quaderförmige Umhausung aus einem Aluminiumrahmen und transparenten Flächenelementen und ist mit einem Hubfenster (13) ausgestattet. Die Fixierungen für die erste und zweite Halterung (9) sind am Boden der Kammer befestigt. Der Roboterarm (4) in der Kammer umfasst eine Grundplatte (2), auf der ein Gehäuse, das die Antriebseinheit umfasst, aufgesetzt ist. Die Antriebseinheit umfasst einen Motor, ein Getriebe und einen Winkelgeber. Auf dem Gehäuse sind die über Gelenke miteinander verbundenen Glieder des Roboterarms (4) angebracht. Der am Endglied des Roboterarms (4) angebrachte Endeffektor (6) umfasst ein dünnes, hufeisenförmiges Blech als Auflagefläche und ist mit einer Unterdruckversorgung ausgestattet, so dass eine Halbleiterscheibe auf die Auflagefläche aufgelegt und durch Unterdruck an diese fixiert werden kann. Ein Wafer Mapping Sensor des Typs M-DW1 des Herstellers Panasonic ist so am Endeffektor (6) angebracht, dass er dem hufeisenförmiges Blech gegenüber und mit diesem in einer Ebene, die parallel zur Auflagefläche ausgerichtet ist, liegt. Die Ablagestation (7) in der Kammer umfasst mehrere konzentrisch angeordnete Stufen, die zum Kreismittelpunkt abfallen und mit Einstecköffnungen für Pins zur Auflage der Halbleiterscheibe ausgestattet sind. Durch einen radial verlaufenden quaderförmigen Spalt in der Mitte wird die Ablagestation (7) in zwei gleichgroße Kreissegmente mit drei in Radialinnwärtsrichtung abfallenden Stufen unterteilt. Die Vorrichtung zur Ausrichtung (11) der Halbleiterscheiben ist ein dreiachsiger Prealigner der Serie LPA des Herstellers Logosol Inc. USA. Das Lesegerät (12) des Typs WID120 des Herstellers IOSS ist seitlich an der Basis des Prealigners unterhalb der Auflagefläche angebracht und nach oben ausgerichtet ist. Die Steuerungseinheit (10) umfasst einen Bildschirm und ein Bedienelement, beispielsweise ein Programmiergerät des Typs iPendant des Herstellers FANUC, und ist außerhalb der Kammer seitlich am Rahmen des Gehäuses drehbar befestigt. Das Speichermedium oder die Datenbank ist beispielsweise das Programmiergerät, ein externes Speichermedium oder eine externe Datenbank, über die die Vorrichtung mittels eines zusätzlichen Computers verbunden ist.

Mit der erfindungsgemäßen Vorrichtung wurden gemäß dem erfindungsgemäßen Verfahren vollautomatisch 25 Silizium-Halbleiterscheiben mit einer Dicke von 750 µm und einem Durchmesser von 200 mm innerhalb von weniger als 2 Stunden von einer ersten in eine zweite FOSB-Kassette (9) umsortiert und ausgerichtet. Außerdem konnten so vollautomatisch 25 Silizium-Halbleiterscheiben mit einer Dicke von 750 µm, einem Durchmesser von 200 mm und einer Galliumnitrid-Beschichtung innerhalb von weniger als 2 Stunden von einer ersten in eine zweite FOSB-Kassette (9) umsortiert und ausgerichtet werden, ohne dass durch das Verfahren Defekte auf der Oberfläche der Scheiben erzeugt wurden. Dabei wurde auch die Lasermarkierung für jede Scheibe ausgelesen.

## Patentansprüche

1. Verfahren zum Sortieren und Ausrichten von Halbleiterscheiben, umfassend die folgenden Schritte
Erkennung einer ersten Halterung für mehrere Halbleiterscheiben und deren Beladungszustand,
Entnahme einer Halbleiterscheibe aus der ersten Halterung;
Ausrichtung der Halbleiterscheibe gemäß einer vorgegebenen Orientierung;
Erkennen und Auslesen einer Lasermarkierung auf der Halbleiterscheibe;
Speicherung der in der Lasermarkierung enthaltenen Informationen in einer Datenbank oder einem Speichermedium; und
Einsortieren der orientierten Halbleiterscheibe in eine zweite Halterung für mehrere Halbleiterscheiben;
wobei diese Verfahrensschritte automatisiert durchgeführt werden.

2. Verfahren zum Sortieren und Ausrichten von Halbleiterscheiben gemäß dem Anspruch 1, **dadurch gekennzeichnet, dass** die im Anspruch 1 genannten Verfahrensschritte vollautomatisch durchgeführt werden.

3. Verfahren zum Sortieren und Ausrichten von Halbleiterscheiben gemäß dem Anspruch 1 oder 2, **dadurch gekennzeichnet, dass** die Schritte in der im Anspruch 1 angegebenen Reihenfolge durchgeführt werden.

4. Verfahren zum Sortieren und Ausrichten von Halbleiterscheiben gemäß einem der Ansprüche 1 bis 3, **dadurch gekennzeichnet, dass** das Verfahren einen zusätzlichen Schritt zur Begutachtung der Halbleiterscheibe umfasst.

5. Verfahren zum Sortieren und Ausrichten von Halbleiterscheiben gemäß einem der Ansprüche 1 bis 4, **dadurch gekennzeichnet, dass** die Erkennung der ersten Halterung für mehrere Halbleiterscheiben und deren Beladungszustand mit Hilfe eines optoelektronischen Sensors erfolgt.

6. Verfahren zum Sortieren und Ausrichten von Halbleiterscheiben gemäß einem der Ansprüche 1 bis 5, **dadurch gekennzeichnet, dass** das Verfahren für alle Halbleiterscheiben der ersten Halterung durchgeführt wird.

7. Verfahren zum Sortieren und Ausrichten von Halbleiterscheiben gemäß einem der Ansprüche 1 bis 6, **dadurch gekennzeichnet, dass** 100 bis 160 Halbleiterscheiben in 8 Stunden umsortiert und ausgerichtet werden.

8. Verfahren zum Sortieren und Ausrichten von Halbleiterscheiben gemäß einem der Ansprüche 1 bis 7, **dadurch gekennzeichnet, dass** die Halbleiterscheiben einen Durchmesser von 150 bis 300 mm und eine Dicke von 500 bis 1500 µm aufweisen.

9. Vorrichtung zum Sortieren und Ausrichten von Halbleiterscheiben, mit einer Kammer und einer Steuerungseinheit (10), wobei die Kammer die folgenden Einheiten umfasst
eine erste Fixierung (8) für eine erste Halterung (9) für mehrere Halbleiterscheiben;
eine zweite Fixierung (8) für eine zweite Halterung (9) für mehrere Halbleiterscheiben;
einen Roboterarm (4) mit einem Endeffektor (6), der ein Auflageelement zur Aufnahme und zum Transport einer Halbleiterscheibe und einen optoelektronischen Sensor umfasst;
eine Ablagestation (7) für eine Halbleiterscheibe, die so ausgestaltet ist, dass die Halbleiterscheibe mittels des Endeffektors (6) abgelegt und entnommen werden kann;
eine Vorrichtung (11) zur Ausrichtung der Halbleiterscheibe mittels Drehung;
und
ein Lesegerät (12) zur Identifikation einer Lasermarkierung am Rand der Halbleiterscheibe;
wobei die Steuerungseinheit (10) zur automatisierten Steuerung des Roboterarms ausgelegt ist, und
der optoelektronische Sensor und das Lesegerät (12) mit einer Datenbank oder einem Speichermedium gekoppelt sind.

10. Vorrichtung zum Sortieren und Ausrichten von Halbleiterscheiben gemäß dem Anspruch 9, wobei das Auflageelement zur Aufnahme und zum Transport der Halbleiterscheibe ein hufeisenförmiges Bauteil ist.

11. Vorrichtung zum Sortieren und Ausrichten von Halbleiterscheiben gemäß dem Anspruch 9 oder 10, wobei der Roboterarm eine Unterdruckversorgung umfasst und das Auflageelement zur Aufnahme und zum Transport der Halbleiterscheibe einen Unterdruckkanal umfasst, der mit der Unterdruckversorgung verbunden ist.

12. Vorrichtung zum Sortieren und Ausrichten von Halbleiterscheiben gemäß einem der Ansprüche 9 bis 11, wobei die Vorrichtung (11) zur Ausrichtung der Halbleiterscheibe ein dreiachsiger Prealigner ist.

13. Vorrichtung zum Sortieren und Ausrichten von Halbleiterscheiben gemäß einem der Ansprüche 9 bis 12, wobei der optoelektronischen Sensor eine Lichtquelle umfasst, die Licht einer Wellenlänge von 600 bis 750 nm emittiert.

14. Vorrichtung zum Sortieren und Ausrichten von Halbleiterscheiben gemäß einem der Ansprüche 9 bis 13, wobei die Vorrichtung so ausgestaltet ist, dass sie zum Sortieren, Ausrichten und zur Begutachtung von Halbleiterscheiben mit Durchmessern von 150 bis 300 mm und Dicken von 500 bis 1500 µm geeignet ist.

15. Vorrichtung zum Sortieren und Ausrichten von Halbleiterscheiben gemäß einem der Ansprüche 9 bis 14, wobei die Vorrichtung für einen Reinraum der Klasse 4 oder niedriger gemäß ISO EN 14644-1 geeignet ist.
